Europäisches Patentamt

European Patent Office

Office européen des brevets

(19)

(11) Veröffentlichungsnummer: **0 152 502**
**B1**

(12) **EUROPÄISCHE PATENTSCHRIFT**

(45) Veröffentlichungstag der Patentschrift: **17.05.89**

(51) Int. Cl.⁴: **H 01 J 37/147,** H 01 J 37/295

(21) Anmeldenummer: **84101691.8**

(22) Anmeldetag: **18.02.84**

(54) Vorrichtung zur Untersuchung von Kristalloberflächen nach der LEED-Technik.

(43) Veröffentlichungstag der Anmeldung:
28.08.85 Patentblatt 85/35

(45) Bekanntmachung des Hinweises auf die Patenterteilung:
17.05.89 Patentblatt 89/20

(84) Benannte Vertragsstaaten:
CH DE FR GB IT LI

(56) Entgegenhaltungen:
DE-A-3 205 027
GB-A-1 407 223
JOURNAL OF APPLIED PHYSICS, Band 48, Nr. 12, Dezember 1977, Seiten 5027-5032, American Institute of Physics, New York, US; C. BERGER et al.: "Preliminary study for the construction of a low-energy electron-diffraction apparatus using a high-tension source"
OPTIK, Band 53, Nr. 4, Juli 1979, Seiten 281-284, Wissenschaftliche Verlagsgesellschaft mbH, Stuttgart, DE; T. SOMA: "A practical focus-deflection system for shaped electron beams"

(73) Patentinhaber: LEYBOLD AKTIENGESELLSCHAFT
Bonner Str. 504
D-5000 Köln 51 (DE)

(72) Erfinder: Henzler, Martin, Prof. Dr.
Finkenweg 6
D-3008 Garbsen 5 (DE)

(74) Vertreter: Leineweber, Jürgen, Dipl.-Phys.
Nagelschmiedshütte 8
D-5000 Köln 40 (DE)

(56) Entgegenhaltungen:
"Advances in image pickup and display", Band 1, 1974, Seiten 196-209, Ausg. B. Kazan, Academic Press, New York und London;

EP 0 152 502 B1

**Beschreibung**

Die Erfindung bezieht sich auf eine Vorrichtung zur Untersuchung von Kristalloberflächen nach der LEED-Technik (Low Energy Electron Diffraction) durch Beschuß mit niederenergetischen Elektronen mit einer Energie von 20 bis 500 eV mit einem Ablenksystem mit mehreren symmetrisch un eine Achse angeordneten Ablenkplatten und mit einem dem Ablenksystem nachgeordneten Detektor.

Bei der sogenannten LEED-Technik (Low Energy Electron Diffraction) wird eine Kristalloberfläche mit niederenergetischen Elektronen (20 bis 500 eV) beschossen. An den Strukturen der Kristalloberfläche treten Beugungserscheinungen auf, die zu Streuungen mit bevorzugten Richtungen führen. Die Feststellung dieser bevorzugten Richtungen kann durch Messung der Winkelverteilung der gestreuten Elektronen erfolgen. Eine andere Methode besteht darin, die gestreuten Elektronen mit Hilfe eines Leuchtschirmes sichtbar zu machen. Bei einer regelmäßigen Struktur der Kristalloberfläche entstehen regelmäßige Beugungsbilder, die sich aus einzelnen Beugungsreflexen zusammensetzen. Bei Abweichungen von der Regelmäßigkeit liegen Defekte der Oberflächenstruktur vor. Durch das Ablenksystem wird eine genaue Messung der Winkelverteilung der von der Probe gestreuten Elektronen möglich, ohne daß eine mechanische Bewegung des Kristalls oder des Detektors notwendig ist.

Für die Messung der Winkelverteilung bei der LEED-Technik ist der Einsatz von Anlenksystemen bekannt, die aus vier Ablenkplatten (vgl. Surface Science, 117, 1982, S. 180—187) bestehen. Die Platten werden derart mit Spannungen versorgt, daß in dem von den Bauteilen umschlossenen Raum ein möglichst homogenes elektrisches Feld herrscht, dessen Richtung einstellbar ist. Aufgabe dieser Ablenksysteme ist es, Teilchenstrahlen, welche an einer beliebigen Stelle in das Ablenksystem eintreten, derart umzulenken, daß sie auf die Eintrittsöffnungen eines dem Ablenksystem nachgeordneten Detektors auftreffen. Nachteilig an den vorbekannten Ablenksystemen sind die störenden, nicht homogenen Randfeldbereiche, die den nutzbaren Eintritts-Winkelbereich beschränken. Außerdem besteht der Nachteil, daß die Nachweisempfindlichkeit der vorbekannten Ablenksysteme von Winkel des Eintritts des Teilchenstrahls in das Ablenksystem abhängig ist.

Der vorliegenden Erfindung liegt die Aufgabe zugrunde, ein Ablenksystem der eingangs genannten Art mit möglichst kleinen inhomogenen Randbereichen und vom Eintrittswinkel unabhängiger Nachweisempfindlichkeit zu schaffen.

Erfindungsgemäß wird diese Aufgabe dadurch gelöst, daß acht in ihrer Längsrichtung je auf gleiche Weise in zwei Elektroden geteilte Ablenkplatten vorgesehen sind, welche Elektroden einen ersten und einen in Bewegungsrichtung der Elektronen daran anschließenden zweiten Ablenksystemabschnitt bilden, und daß das Längenverhältnis und die Spannungsversorgung der Elektroden der Abschnitte derart gewählt sind, daß die Elektronen das Ablenksystem parallel zu oder auf seiner Achse verlassen und auf die Eintrittsöffnung des Detektors fallen. Bei einem in dieser Weise gestalteten Ablenksystem läßt sich mit Hilfe eines geeigneten Widerstandsnetzwerkes die Spannung in der Weise zuführen, daß ein optimal großer Bereich mit einer homogenen Feldstärke erzielbar ist. Eine solche Anordnung erlaubt im Vergleich mit den vorbekannten Ablenksystemen bei gleicher Baugröße größere Ablenkwinkel und kleinere Abweichungen von der Linearität der Ablenkung gegen die Ablenkspannung. Durch die Maßnahme und nach der Erfindung wird weiterhin erreicht, daß die Elektronen stets senkrecht auf den Detektor fallen. Dadurch wird auch bei großen Emissionswinkeln, d. h. bei einem relativ großen Winkel zwischen der Achse des Systems und den in das System eintretenden Elektronen, eine konstante Nachweisempfindlichkeit erreicht. Gleichzeitig findet eine wirkungsvolle Energieanalyse durch das Gegenfeld im Detektor statt. Der nutzbare Winkelbereich am Kristall kann durch diese Maßnahmen von 3° auf 45° erhöht werden.

Die Verwendung von Elektrodensystemen für geladene Teilchen mit acht Elektroden ist zwar vielfach bekannt (vgl. D1: Advances in Image Pickup and Display, Academic Press, New York and London, 1974, p. 196—209; D2: A practical focus-deflection system for shaped electron beams, Optik 53, 1979, Nr. 4, S. 281—284; D3: Ion optics for ion microprobe instruments, Vacuum, volume 33, number 9, p. 525—531; D4: DE—OS 32 05 027; D5: GB—PS 1 407 223); Hinweise darauf, wie solche Systeme bei der LEED-Technik auszubilden und mit Spannungen zu versorgen sind, um bei möglichst kleinen inhomogenen Randbereichen eine vom Eintrittswinkel unabhängige Nachweisempfindlichkeit zu erzielen, enthalten diese Literaturstellen jedoch nicht.

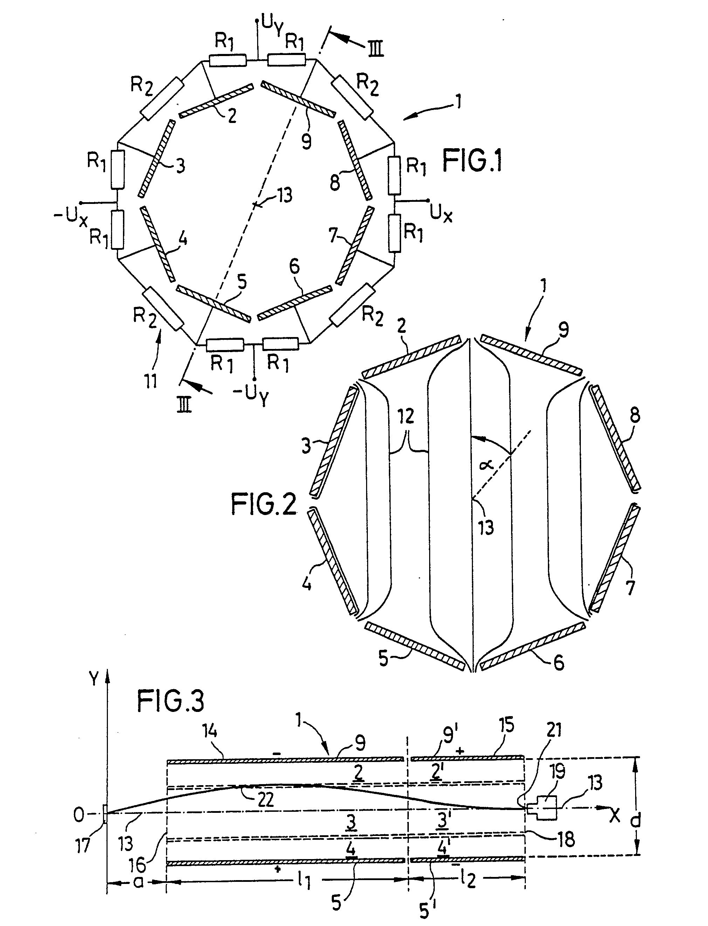

Weitere Vorteile und Einzelheiten der Erfindung sollen anhand von in den Figuren 1 bis 3 dargestellten Ausführungsbeispielen erläutert werden.

Die Figuren 1 und 2 zeigen Ausführungsbeispiele für das erfindungsgemäße Ablenksystem 1 im Querschnitt. Es umfaßt acht Ablenkplatten 2 bis 9, die derart rotationssymmetrisch angeordnet sind, daß ihre Ebenen tangential liegen.

Aus Fig. 1 ist die Spannungsversorgung der Ablenkplatten ersichtlich. Sie besteht aus einem Widerstandsnetzwerk 11 mit jeweils vier abwechselnd zu einem Kreis geschalteten Einfach-Widerständen $R_2$ und Doppel-Widerständen $R_1$. Die Zwischenpunkte zwischen den Einfach-Widerständen $R_2$ einerseits und den Doppel-Widerständen $R_1$ andererseits sind mit den Ablenkplatten verbunden und versorgen diese mit der gewünschten Spannung. Zwischen den insgesamt vier Paaren von Doppel-Widerständen $R_1$ erfolgt die Zuführung verschiedener Ablenkspannungen $U_x$, $U_y$ bzw. $-U_x$ und $-U_y$. Zweckmäßig sind Spannungswerte bis zu $\pm 150$ V. Die Größe der Widerstände beträgt zweckmäßigerweise einige Hundert k$\Omega$, wobei zwischen der Größe der Widerstände $R_1$ und $R_2$ die Beziehung $R_2 = \sqrt{2} \cdot R_1$ besteht.

In Fig. 2 sind Feldlinien 12 für einen bestimmten Spannungszustand dargestellt. Bis auf schmale Randbereiche herrscht im Ablenksystem 1 ein homogenes elektrisches Feld. Durch Veränderung der Ablenkspannungen $\pm U_x$ und $\pm U_y$ kann dieses Feld um die zentrale Achse 13 des Systems 1 gedreht werden. Hinsichtlich des Winkels $\alpha$ gilt die Formel

$$\alpha = \mathrm{arc\ tg}\ (U_y/U_x).$$

Dadurch ist es möglich, die an verschiedenen Orten in das homogene elektrische Feld eintretenden, z. B. aus Elektronen bestehenden Strahlenbündel so abzulenken, daß sie das Ablenksystem im Bereich der Achse 13 verlassen.

Fig. 3 zeigt einen Längsschnitt durch ein Ablenksystem 1 nach der Erfindung. Es besteht aus zwei Abschnitten 14 und 15 von der Länge $1_1$ und $1_2$. Der Abstand der Eintrittsöffnung 16 des ersten Abschnittes 14 von der Probe 17 ist mit a bezeichnet. Mit d ist der Abstand von zwei einander gegenüberliegenden Platten der beiden Abschnitte 14, 15 bezeichnet. Identisch mit der Achse 13 des Systems ist die x-Achse eines in die Skizze eingetragenen Koordinatensystems. Die Probe 17 ist im Nullpunkt dieses Systems angeordnet. Im Bereich der Austrittsöffnung 18 des zweiten Abschnittes 15 ist ein Detektor 19 derart angeordnet, daß seine Eintrittsöffnung 21 auf der Achse 13 liegt. Die Schnittdarstellung nach Fig. 3 entspricht der in Fig. 1 dargestellten Linie III—III. Dadurch sind vom ersten Abschnitt 14 des zweiteiligen Ablenksystems 1 nach Fig. 3 die Ablenkplatten 2 bis 5 und 9 sichtbar. Im zweiten Abschnitt 15 sind es in entsprechender Weise die Ablenkplatten 2' bis 5' und 9'.

Als Beispiel für die Wirkung des zweiteiligen Ablenksystems 1 nach Fig. 3 ist eine Teilchenbahn 22 eingezeichnet. Von der Probe 17 ausgehend treten die Teilchen unter einem bestimmten Winkel in den ersten Abschnitt 14 ein und werden dort in Richtung Achse 13 abgelenkt. Die Spannungen an den Ablenkplatten sind so gewählt, daß der Ort des Eintritts in den ersten Abschnitt 14 annähernd den gleichen Abstand von der Achse 13 hat wie der Ort des Austritts aus dem Abschnitt 14. Die Ablenkplatten des Abschnittes 15 werden invers derart mit Spannungen versorgt, daß die Teilchenbahn 22 im Bereich der Eintrittsöffnung 21 des Detektors 19 mit der Achse 13 zusammenfällt.

Um diese gewünschte Wirkung zu erzielen, muß zwischen den Feldstärken $E_1$ und $E_2$ in den Abschnitten 14 und 15 und den Abmessungen der Abschnitte die folgende Bedingung zumindest in etwa erfüllt sein:

$$a = (1_2^2 + 2\ 1_1 1_2 - \frac{E_1}{E_2} 1_1^2)/(2\ 1_2 - 2 \frac{E_1}{E_2} 1_1)$$

Dabei ist $1_1$ vorzugsweise doppelt so groß wie $1_2$. Als zweckmäßige Breite der Ablenkplatten 2 bis 9 hat sich 16 mm ergeben.

**Patentansprüche**

1. Vorrichtung zur Untersuchung von Kristalloberflächen nach der LEED-Technik (Low Energy Electron Diffraction) durch Beschuß mit niederenergetischen Elektronen mit einer Energie von 20 bis 500 eV mit einem Ablenksystem (1) mit mehreren symmetrisch um eine Achse (13) angeordneten Ablenkplatten (2 bis 9) und mit einem dem Ablenksystem (1) nachgeordneten Detektor (19), dadurch gekennzeichnet, daß acht in ihrer Längsrichtung je auf gleiche Weise in zwei Elektroden geteilte Ablenkplatten (2 bis 9) vorgesehen sind, welche Elektroden einen ersten und einen in Bewegungsrichtung der Elektronen daran anschließenden zweiten Ablenksystemabschnitt (14, 15) bilden und daß das Längenverhältnis und die Spannungsversorgung der Elektroden der Abschnitte (14, 15) derart gewählt sind, daß die Elektronen das Ablenksystem (1) parallel zu oder auf seiner Achse (13) verlassen und auf die Eintrittsöffnung (21) des Detektors fallen.

2. Vorrichtung nach Anspruch 1, wobei der Detektor (19) auf der Achse (13) angeordnet ist, dadurch gekennzeichnet, daß das Längenverhältnis und die Spannungsversorgung der von den geteilten Ablenkplatten (2 bis 9) gebildeten Abschnitte (14, 15) derart gewählt sind, daß der Ort des Eintritts der Elektronen in den ersten Abschnitt (14) annähernd den gleichen Abstand von der Achse (13) hat wie der Ort des Austritts der Elektronen aus dem Abschnitt (14) und daß die Elektronen den Abschnitt (15) auf der Achse (13) verlassen.

3. Vorrichtung nach Anspruch 2, wobei im Abstand (a) vor dem Ablenksystem (1) eine Probe angeordnet ist, dadurch gekennzeichnet, daß die Längen $1_1$ und $1_2$ der beiden Abschnitte sowie die Feldstärken $E_1$ und $E_2$ innerhalb dieser Abschnitte (14, 15) die folgende Bedingung zumindest annähernd erfüllen:

$$a = (1_2^2 + 2\ 1_1 1_2 - \frac{E_1}{E_2} 1_1^2)/(2\ 1_2 - 2 \frac{E_1}{E_2} 1_1)$$

4. Vorrichtung nach Anspruch 3, dadurch gekennzeichnet, daß die Länge $(1_1)$ des — in Bezug auf die Richtung der Elektronen — ersten Abschnittes (14) des Ablenksystemes (1) doppelt so groß ist wie die Länge $(1_2)$ des zweiten Abschnittes (15).

## Revendications

1. Dispositif d'examen de surfaces de cristaux selon la technique LEED (Low Energy Electron Diffraction = diffraction d'électrons à faible énergie), par bombardement au moyen d'électrons peu énergétiques ayant une énergie de 20 à 500 eV, avec un système de déviation (1) ayant plusieurs plaques de déviation (2 à 9) agencées symétriquement autour d'un axe (13) et avec un détecteur (19) disposé à la suite du système de déviation (1), caractérisé par le fait qu'il est prévu huit plaques de déviation (2 à 9) qui sont partagées, chacune de la même manière sur sa direction longitudinale, en deux électrodes, lesquelles électrodes forment une première portion (14) du système de déviation et, succédant à celle-ci dans la direction du mouvement des électrons, une deuxième portion (15) du système de déviation, et par le fait que le rapport des longueurs et l'alimentation en tension des électrodes des portions (14, 15) sont choisis de manière que les électrons quittent le système de déviation (1) parallèlement à son axe (13), ou sur celui-ci, et tombent sur l'ouverture d'entrée (21) du détecteur.

2. Dispositif selon revendication 1, le détecteur 19 étant agencé sur l'axe (13), caractérisé par le fait que le rapport des longueurs et la tension d'alimentation des portions (14, 15) constituées par les plaques de déviation partagées (2 à 9) sont choisis de manière que l'emplacement de l'entrée des électrons dans la première portion (14) soit approximativement à la même distance de l'axe (13) que l'emplacement de la sortie des électrons sortant de la portion (14) et que les électrons quittent la portion (15) sur l'axe (13).

3. Dispositif selon revendication 2, un spécimen étant agencé devant le système de déviation (1), à une distance (a), caractérisé par le fait que les longueurs $1_1$, et $1_2$ des deux portions, ainsi que les intensités $E_1$ et $E_2$ des champs à l'intérieur de ces portions (14, 15) satisfont au moins approximativement à la condition suivante:

$$a = (1_2^2 + 2\,1_1 1_2 - \frac{E_1}{E_2}\,1_1^2)/(2\,1_2 - 2\frac{E_1}{E_2}\,1_1)$$

4. Dispositif selon revendication 3, caractérisé par le fait que la longueur $(1_1)$ de celle des portions (14) du système qui est la première en considérant la direction des électrons est double de la longueur $(1_2)$ de la deuxième portion (15).

## Claims

1. Apparatus for examining crystal surfaces by the low energy electron diffraction method by bombardment with low energy electrons having an energy of 20 to 500 eV with a deflection system (1) having several deflection plates (2 to 9) arranged symmetrically round an axis (13) and with a detector (19) following the deflection system (1), characterised in that eight deflection plates (2 to 9) each divided in the same manner in their longitudinal direction into two electrodes are provided, which electrodes form a first deflection system portion (14) and a second deflection system portion (15) which follows the first in the direction of movement of the electrons and in that the length ratio and the power supply to the electrodes of the portions (14, 15) are selected such that the electrons leave the deflection system (1) parallel to or at its axis (13) and impinge on the inlet opening (21) of the detector.

2. Apparatus according to claim 1, wherein the detector (19) is arranged at the axis (13), characterised in that the length ratio and the power supply of the portions (14, 15) formed by the divided deflection plates (2 to 9) are selected such that the location where the electrons enter the first portion (14) is at approximately the same distance from the axis (13) as the location where the electrons leave the portion (14) and in that the electrons leave the portion (15) at the axis (13).

3. Apparatus according to claim 2, wherein a sample is arranged at a distance (a) in front of the deflection system (1), characterised in that the lengths $1_1$ and $1_2$ of the two portions as well as the field strengths $E_1$ and $E_2$ inside these portions (14, 15) satisfy the following condition at least approximately:

$$a = (1_2^2 + 2\,1_1 1_2 - \frac{E_1}{E_2}\,1_1^2)/(2\,1_2 - 2\frac{E_1}{E_2}\,1_1)$$

4. Apparatus according to claim 3, characterised in that the length $(1_1)$ of the first portion (14) of the deflection system (1) — with respect to the direction of the electrons — is twice as great as the length $(1_2)$ of the second portion (15).

4

EP 0 152 502 B1

FIG.1

FIG.2

FIG.3